# EUROPEAN PATENT SPECIFICATION

(11) **EP 3 404 198 B1**
(45) Date of publication and mention of the grant of the patent: **18.12.2019**
(21) Application number: 17171982.6
(22) Date of filing: 19.05.2017
(51) Int. Cl.: E21B 41/00, H01F 27/12, H05K 5/06, E21B 33/035

(54) **A COOLING ARRANGEMENT OF A SUBSEA INSTALLATION**
KÜHLANORDNUNG EINER UNTERWASSERINSTALLATION
AGENCEMENT DE REFROIDISSEMENT D'UNE INSTALLATION SOUS-MARINE

(43) Date of publication of application: 21.11.2018
(73) Proprietor: ABB Schweiz AG, 5400 Baden (CH)
(72) Inventor: Launonen, Markku, 65320 Vaasa (FI); Missing, Kim, 65320 Vaasa (FI)
(74) Representative: Kolster Oy Ab

(56) References cited:
- EP-A1- 2 169 690
- EP-A1- 2 924 231
- EP-A1- 2 988 311
- EP-A1- 3 048 619
- WO-A1-2011/088840
- WO-A1-2014/071985
- WO-A1-2015/104050

## Description

### FIELD OF THE INVENTION

The present invention relates to a cooling arrangement of a subsea installation, and particularly to a cooling arrangement of a subsea installation comprising a pressure compensator for fluids.

### BACKGROUND OF THE INVENTION

Subsea installations are assemblies comprising several apparatuses used under water. Said assemblies can be installed for example on the bottom ground of a sea. As an example of said subsea installations power transformers used under water can be mentioned. Typically these power transformers comprise a tank filled with insulation and/or cooling fluid to encounter for the high pressure due to deep water depth. Examples of the other subsea liquid filled objects are subsea motors, subsea switchgears, subsea frequency converters, rectifiers, combined subsea frequency converters/subsea transformers and hydraulic store tanks.

During operation of the subsea installation, the power losses of the electrical installations inside the tank increase the temperature and volume of the insulation and/or cooling fluid. The fluid volume shall also change due to fluid compression when the installation is submerged from ambient air pressure into the sea bottom having high hydrostatic pressure. The volume variation is often compensated with a pressure compensator, which is in fluid communication with the tank of the installation. The insulation and/or cooling fluid is often cooled via the outer surface of the tank to the surrounding sea water. As the area of the outer surface of the tank is limited there is a need to provide additional cooling for the insulation and/or cooling fluid. However, external additional dedicated fluid coolers are expensive and increase the complexity of the subsea installation.

WO 2011/088840 discloses a system for pressure compensation, particularly for pressure compensation in a subsea environment. The system comprises a fluid filled enclosure surrounding a cavity, a first pressure compensator having a first chamber and a second chamber, the first chamber being in fluid communication with the cavity and a second pressure compensator having a third chamber and a fourth chamber. The third chamber of the second pressure compensator is in fluid communication with the second chamber of the first pressure compensator.

EP 2 924 231 discloses a pressure compensation system for compensating volume variations of a liquid in a chamber of a subsea device is provided. A subsea enclosure of the subsea device encloses the chamber. A first pressure compensator has a first compensation volume and provides pressure balancing between ambient medium surrounding the subsea device and the first compensation volume. A first biasing device is configured to bias the first pressure compensator such that the pressure in the first compensation volume is higher than the pressure in the ambient medium surrounding the subsea device. A second pressure compensator has a second compensation volume and provides pressure balancing between the ambient medium and the second compensation volume. A second biasing device biases the second pressure compensator such that the pressure in the second compensation volume is higher than the pressure in the ambient medium. A control unit is connected to control first and second valves arranged in flow connections between the first and second compensation volumes and the chamber.

### BRIEF DESCRIPTION OF THE INVENTION

An object of the present invention is to provide a cooling arrangement of a subsea installation to solve the above problems. The objects of the invention are achieved by a cooling arrangement of a subsea installation which is characterized by what is stated in the independent claims. The preferred embodiments of the invention are disclosed in the dependent claims.

The invention is based on the idea of providing a cooling arrangement of a subsea installation. The subsea installation comprises a tank and a pressure compensator, the tank comprising an insulation fluid or other fluid. The pressure compensator is in fluid communication with the tank and the pressure compensator is configured to compensate volume variations of the insulation fluid or the other fluid by performing an expansive and a contracting movement. The tank and the pressure compensator are connected with a first fluid flow connection and a second fluid flow connection, and the first fluid flow connection provides a flow path from the tank to the pressure compensator and the second fluid flow connection provides a flow path from the pressure compensator to the tank. The first fluid flow connection and the second fluid flow connection provides a fluid circulation path between the tank and the pressure compensator.

An advantage of the cooling arrangement of a subsea installation of the invention is that it utilizes existing components thus making a smaller size and smaller costs of the subsea installation possible.

### BRIEF DESCRIPTION OF THE DRAWINGS

In the following the invention will be described in greater detail by means of preferred embodiments with reference to the attached drawings, in which
- Figure 1: shows a cooling arrangement of a subsea installation;
- Figure 2: shows a cooling arrangement of a subsea installation;
- Figure 3: shows a cooling arrangement of a subsea installation;
- Figure 4: shows a cooling arrangement of a subsea installation;
- Figure 5: shows a cooling arrangement of a subsea installation;
- Figure 6: shows a cooling arrangement of a subsea installation;
- Figure 7: shows a cooling arrangement of a subsea installation;
- Figure 8: shows a cooling arrangement of a subsea installation.

### DETAILED DESCRIPTION OF THE INVENTION

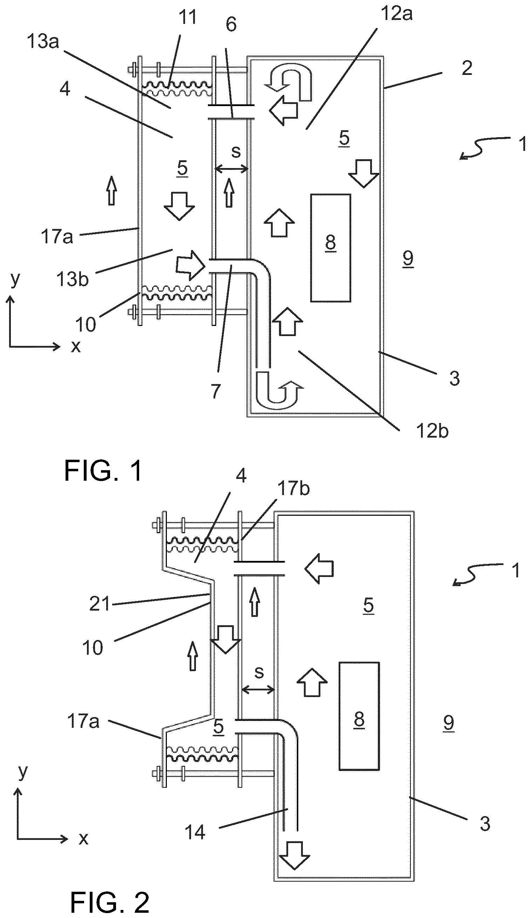

Figure 1 shows a cooling arrangement 1 of a subsea installation 2. The subsea installation 2 comprises a tank 3 and a pressure compensator 4. The tank 3 comprises an insulation fluid 5 or other fluid. The insulation fluid 5 or other fluid is or at least comprises a liquid, for instance. The pressure compensator 4 is in fluid communication with the tank 3. The pressure compensator 4 is configured to compensate volume variations of the insulation fluid 5 or the other fluid by performing an expansive and a contracting movement. The tank 3 and the pressure compensator 4 are connected with a first 6 and a second fluid flow connections 7. The first fluid flow connection 6 provides a flow path from the tank 3 to the pressure compensator 4. The second fluid flow connection 7 provides a flow path from the pressure compensator 4 to the tank 3. The pressure compensator 4 has a fluid communication through two connections into the tank 3 of the subsea installation 2 and so the pressure compensator 4 is able to operate as a cooler.

Same reference signs used in Figures 1-8 refer to corresponding parts in Figures.

As shown in Figures 1-8 the subsea installation 2 comprises a heat generating electric apparatus 8. The heat generating electric apparatus 8 is located within the tank 3 at least partially and generates heat which is transferred to the insulation fluid 5 or the other fluid. The heat generating electric apparatus 8 or parts of the apparatus 8 are preferably submerged in the insulation fluid 5 or the other fluid. The subsea installation 2 may also comprise a plurality of heat generating electric apparatuses 8. Some heat is generated also in the tank walls 3 of the subsea installation 2, when the subsea installation is a subsea transformer, for instance.

The heat load produced by the heat generating electric apparatus 8 depends on the loading of the apparatus 8. Examples of heat generating electric apparatuses 8 that can be located within the tank 3 are motors, switchgears, frequency converters, rectifiers and hydraulic store tanks, electric power switches and variable speed drives.

Surrounding water 9 freely flows across an outer wall 10 of the pressure compensator 4 and cools the insulating fluid 5 or another fluid as the heat is dissipated through the outer wall 10 of the pressure compensator 4 to the surrounding water 9.

The cooling arrangement 1 can be driven by natural convection without any pumps or suction devices. The temperature difference between the fluid 5 in a tank 3 and the fluid 5 in the pressure compensator 4 causes the fluid circulation between the tank 3 and the pressure compensator 4. The heat generating electric apparatus 8 in the tank 3 heats the insulation fluid 5 or other fluid in the tank 3 and the heated fluid 5 in the vicinity of the apparatus 8 starts to flow upwards in the tank 3. Part of the heated insulation fluid 5 or other fluid in the tank 3 flows through first fluid flow connection 6 into the pressure compensator 4.

The temperature difference between the insulation fluid 5 or other fluid in a pressure compensator 4 and the surrounding fluid, sea water 9, causes heat to transfer from the fluid 5 to the surrounding sea water 9. The heat transfer causes a temperature gradient to the fluid 5 and to the surrounding sea water 9 in the pressure compensator 4. The temperature gradient in the fluid 5 causes the fluid 5 to move downwards in the pressure compensator 4. Respectively the temperature gradient in the surrounding sea water 9 along the outer wall 10 of the pressure compensator 4 causes the sea water 9 to move upwards along the outer wall 10. Part of the cooled insulation fluid 5 or other fluid in pressure compensator 4 flows through second fluid flow connection 7 into the tank 3.

The surrounding fluid flow direction is indicated with small arrows and the insulating fluid 5 or other fluid flow direction is indicated with large arrows in the Figures.

The mechanical movements of the pressure compensator 4 improve the heat transfer from the outer wall 10 of the pressure compensator 4 to the surrounding water 9. Large amplitude cycling of the pressure compensator 4 pushes and pulls the surrounding water 9 layer on the outer wall 10 of the pressure compensator 4 causing mixing. However, the mechanical movements are slow having a time constant of hours or days and therefore the change in the heat transfer is insignificant from the cooling point of view.

The pressure compensator 4 receives excess insulation fluid 5 or other fluid from the tank 3 when the fluid's 5 temperature and volume increases due to the heat generation of the heat generating apparatus 8. This causes an expansive movement in the pressure compensator 4. In case of a bellows type of pressure compensator 4 the expansive movement changes the outer wall 10 surface shape from a pleated shape to a more flat shape as the bellows 11 open. The insulation fluid 5 or another fluid returns back to the tank 3 when the fluid's 5 temperature and volume decreases due to the diminished heat generation of the heat generating apparatus 8. In case of a bellows type of pressure compensator 4 the contracting movement changes the outer wall 10 surface shape to a more tight pleated shape as the bellows 11 close.

The dimensioning of a pressure compensator 4 system of a subsea installation 2 is preferably made to allow a full volume variation of the insulation fluid 5 or the other fluid.

As shown in the Figures 1-8, in an embodiment, the first fluid flow connection 6 can be arranged between an upper part 12a of the tank 3 and an upper part 13a of the pressure compensator 4, and the second fluid flow connection 7 can be arranged between a lower part 12b of the tank 3 and a lower part 13b of the pressure compensator 4. This arrangement improves the temperature stratification in the tank 3 and in the pressure compensator 4.

The tank 3 and the pressure compensator 4 can be arranged besides each other in a horizontal direction x at a distance s apart. This embodiment is shown in Figures 1,2,4 and 7. In this arrangement the surrounding water 9 is able to flow between the tank 3 and the outer wall 10 of the pressure compensator 4 in a space provided by the distance s.

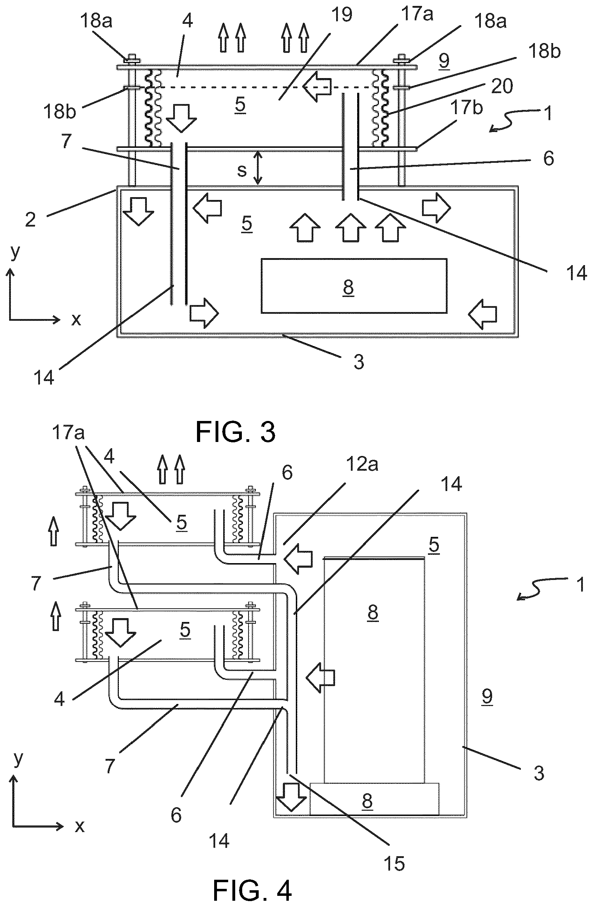

Figures 3, 5 and 6 show an embodiment where the tank 3 and the pressure compensator 4 are arranged the tank 3 below the pressure compensator 4 in a vertical direction y at a distance s apart.

In an embodiment, as shown in Figures 1-8 the first fluid flow connection 6 and/or the second fluid flow connection 7 may comprise fluid flow deflectors 14 inside the tank 3 and/or inside the pressure compensator 4. The fluid flow deflectors 14 can comprise pipes or partial wall structures, for instance. The fluid deflectors 14 are shown as continuous structures in Figures, but they can also comprise several parts. The flow deflectors 14 guide the fluid flow within the tank 3 or within the pressure compensator 4 for keeping the temperature difference between the upper and lower part in the tank 3 or in the pressure compensator 4.

Figure 4 shows an embodiment where the arrangement comprises two pressure compensators 4 in fluid communication with the tank 3. Each of the pressure compensator 4 comprises a first fluid connection 6 between the tank 3 and the pressure compensator 4. Each of the pressure compensator 4 comprises a second fluid connection 7 between the tank 3 and the pressure compensator 4.

In Figure 4 the first fluid connection 6 to the horizontally lower pressure compensator 4 is located in the middle part of the tank 3. However, the first fluid connections 6 to both of the pressure compensators 4 can be located to the upper part 12a of the tank 3 as well.

In an embodiment, as shown in Figure 4, the second fluid flow connections 7 comprise fluid flow deflectors 14 inside the tank 3 which are joined to form a single inlet opening 15 inside the tank. As the cooled fluid 5 flow from a plurality of pressure compensators 4 is guided to one location within the tank 3 excessive mixing of the fluid 5 within the tank 3 is avoided.

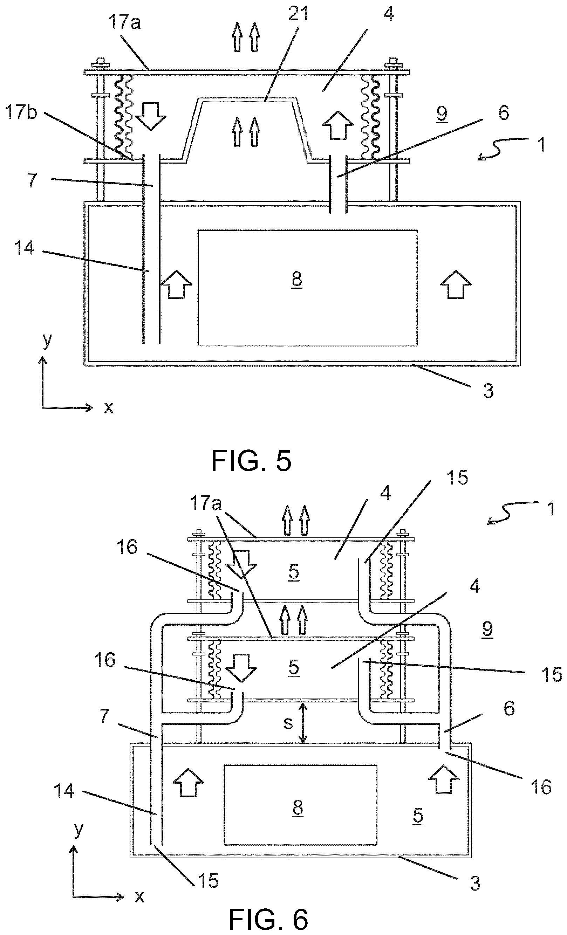

Figure 6 shows an embodiment where the arrangement comprises two pressure compensators 4 in fluid communication with the tank 3. The first fluid flow connection 6 is divided into two fluid flow connections 6 such that the tank 3 comprises one outlet opening 16 and each pressure compensator 4 comprises one inlet opening 15. The second fluid flow connection 7 is divided into two fluid flow connections such that the tank 3 comprises one inlet opening 15 and each pressure compensator 4 comprises one outlet opening 16.

The pressure compensators 4 are connected in parallel in Figure 6. It is also possible to connect the pressure compensators 4 in series. In the series connection the first pressure compensator 4 and the tank 3 are connected with each other with a first 6 and a second 7 fluid flow connections and the second pressure compensator 4 is connected to the first pressure compensator 4 with two fluid flow connections.

In an embodiment the pressure compensator 4 comprises an end wall 17a which is movable providing the expansive and the contracting movement of the pressure compensator 4. In Figures 1-3 and 5-6 the expansive movement of the pressure compensator is directed away from the tank 3. The expansive movement of the pressure compensator may be directed towards the tank 3 by providing a necessary distance between the movable end wall 17a and the tank 3 outer surface.

As shown in Figures 1 and 2 the end wall 17a of the pressure compensator 4 can be movable in the horizontal direction x. The end wall 17a of the pressure compensator can be movable in the vertical direction y as shown in Figures 3-8. It is also possible to arrange the end wall 17a of the pressure compensator to be movable in a direction of a tilted axis of the pressure compensator 4.

In an embodiment the pressure compensator 4 comprises a first travel stop 18a and a second travel stop18b. The first 18a and the second travel stops 18b are configured to block the movement of the movable end wall 17a such that the first travel stop 18a blocks the expansive movement and the second travel stop 18b blocks the contracting movement. Figure 3 shows a position where the movable end wall 17a is between the first 18a and second travel stops 18b.

In an embodiment the first fluid flow connection 6 and the second fluid flow connection 7 in the pressure compensator 4 are arranged to the stationary part which is formed between a stationary end wall 17b and the second travel stop 18b blocks. The stationary part 19 is shown in Figure 3 where a dotted line describes the upper limit defined by the second travel stop 18b.

In an embodiment the pressure compensator 4 comprises a side wall 20 which is foldable and/or flexible providing the expansive and the contracting movement of the pressure compensator 4.

Examples of pressure compensators 4 performing an expansive and a contracting movement are a bellow compensator and a cylinder compensator.

A bellow compensator has one or more foldable and/or flexible side walls 20 for allowing volume variations of the bellow compensator. For instance, an end wall 17a, i.e. a top wall or a bottom wall, may be arranged to move vertically y or horizontally x to compensate for the volume variations of the insulating fluid 5 or other fluid.

Figures 1-6 and 8 show one or more bellow types of pressure compensators as pressure compensators 4. The pressure compensator 4 is in fluid communication with the tank 3. The fluid communication between the bellow compensator and the tank 3 is provided by a fluid flow connections 6,7. The fluid flow connections 6,7 may enter the bellow compensator through the stationary end wall 17b of the bellow compensator. The stationary end wall 17b may be arranged fixedly with respect to the tank 3. The bellow compensator is thus allowed to expand and contract such that its other end wall 17a may move, and its foldable side walls 20 may straighten and fold depending on the fluid volume within the compensator 4. The side walls 20 may comprise two different bellows, an inner steel bellow and an outer rubber bellow. The bellow compensator comprises travel stops 18a-b which are configured to block the vertical y or horizontal x movement of the movable end wall 17a. The travel stops 18a-b limit the vertical y or horizontal x movement of the movable end wall 17a.

Figures 2 and 5 show an embodiment where the end wall of the pressure compensator 4 comprises a recess 21. The recess 21 of the end wall 17a-b is towards the other end wall 17a-b in the pressure compensator 4. The recess 21 is positioned between the first 6 and the second fluid flow connections 7 in the pressure compensator 4. The insulation fluid 5 or other fluid enters into the pressure compensator 4 via the first fluid flow connection 6. Then it travels towards the second fluid flow connection 7 between the recess 21 and the other end wall. The recess 21 reduces the cross sectional area of the fluid 5 flow in the pressure compensator 4 thus increasing the fluid velocity. The recess 21 also provides more outer wall 10 surface for heat transfer. The recess 21 is formed to the movable end wall 17a in Figure 2 and to the stationary end wall 17b in Figure 5. The end wall 17a-b may also comprise several recesses 21.

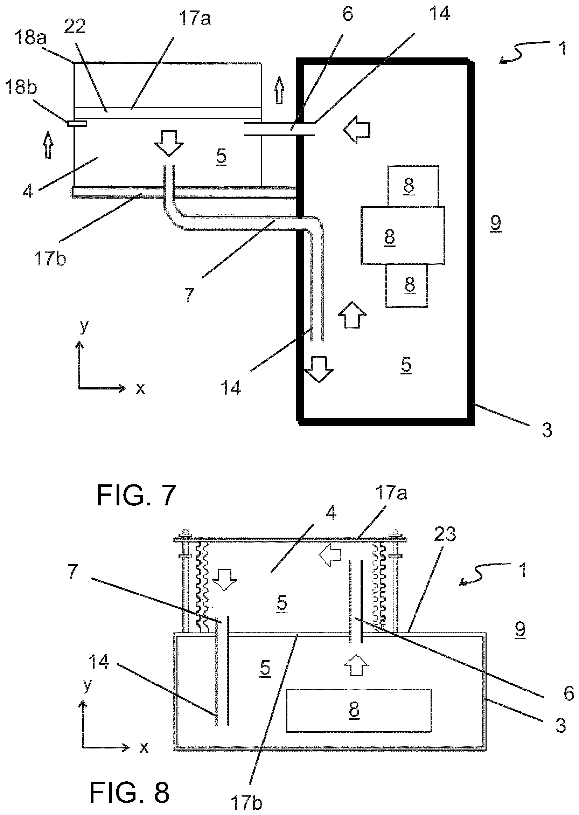

Figure 7 shows a cooling arrangement where the pressure compensator comprises 4 a cylinder compensator. A cylinder compensator has a movable piston 22 which is arranged to compensate for the volume variations of the insulating fluid 5 and which separates the insulating fluid 5 from exterior seawater. For instance, a cylinder compensator is a vertically arranged cylinder housing a piston 22, which can move vertically y due to the volume variations of the insulating 5 or another fluid, e.g. cooling fluid. Below the piston 22 is arranged a fluid space for the insulating fluid 5 and above the piston 22 is a sea water space. The piston 22 is sealed such that mixing of the insulating fluid 5 and seawater 9 is prevented. The pressure compensator 4 comprises travel stops 18a-b which are configured to block the vertical or horizontal movement of the piston. The piston 22 forms the movable end wall 17a of the cylinder compensator.

The fluid communication between the pressure compensator 4 and the tank 3 is provided by fluid flow connections 6,7 such as a connection pipes as shown in Figures. The first fluid flow connection 6 and the second fluid flow connection 7 may comprise pipes comprising a double barrier construction, for instance.

Figure 8 shows an embodiment where the pressure compensator 4 is integrated to the subsea installation 2. A part of top wall 23 of the tank 3 forms a stationary end wall 17b of the pressure compensator 4. The pressure compensator 4 may also be integrated to a part of a side wall which then forms a stationary side wall or a stationary end wall 17b of a pressure compensator 4.

In Figures 1-8 there are shown one or two pressure compensators 4 connected to a tank 3 but the number of the pressure compensators 4 is naturally not limited to one or two but the arrangement can comprise a plurality of pressure compensators 4.

In an embodiment, the subsea installation 2 comprises a subsea transformer. The subsea transformer comprises a transformer tank and the fluid in the tank is transformer oil. The heat generating apparatus 8, the transformer windings and a transformer core, are located in the tank 3 and immersed in the transformer oil. The transformer oil is mineral oil or silicon oil or ester fluid, for instance. A subsea transformer may be operated to reduce high voltage to levels than can be used by pumps, motors and compressors, for instance. Figures 1-8 show arrangements which are suitable for this embodiment.

Cooling of a subsea transformer is not at all trivial case even though it is submerged in oil. By providing additional cooling with the cooling arrangement the parts of heat generating electric apparatus located within the tank can be kept at a lower temperature. For instance, the lifetime of a transformer is increased by keeping the temperature rise of the transformer winding within limits. Another advantage of providing cooling to a transformer is that it increases the loading capability of the transformer which is limited mainly by winding temperature. A further advantage of providing cooling to a transformer is the possibility of obtaining a higher power density in a low volume subsea transformer. Another advantage of the arrangement is that is keeps the temperature of the outer surface of the tank 3 low, which prevents the marine growth on the outer surface. The marine growth on the outer surface would decrease the cooling efficiency.

In an embodiment, the subsea installation 2 comprises a subsea converter transformer. The subsea converter transformer comprises a tank and fluid in the tank. The transformer windings and a transformer core and a converter are located in the tank.

The invented cooling arrangement of a subsea installation can be applied to different types of subsea installations comprising insulation or other fluid in a tank. Examples of such subsea assemblies are subsea transformers, subsea motors, subsea switchgears, subsea frequency converters, rectifiers and hydraulic store tanks and a combinations of these.

The cooling arrangement 1 of a subsea installation 2 can be used in a subsea environment, e.g. exist on the sea bed. The cooling arrangement 1 of a subsea installation 2 is also suitable for deep waters, where the water depth is high, 1000...3000 m, and the prevailing pressure is 100...300 bar. The water temperature in an ocean is typically 5-6°C in the depth of 1000 m and 0-3°C in the depth of 3000 m.

It will be obvious to a person skilled in the art that, as the technology advances, the inventive concept can be implemented in various ways. The invention and its embodiments are not limited to the examples described above but may vary within the scope of the claims.

Part list: 1 a cooling arrangement; 2 a subsea installation; 3 a tank; 4 a pressure compensator; 5 an insulation fluid; 6 a first fluid flow connection; 7 a second fluid flow connection; 8 a heat generating apparatus; 9 water; 10 an outer wall; 11 a bellow; 12a an upper part, 12b a lower part; 13a an upper part, 13b a lower part; 14 a flow deflector; 15 an inlet opening; 16 an outlet opening; 17a-b an end wall; 18 a-b a travel stop; 19 a stationary part; 20 a side wall; 21 a recess; 22 a piston; 23 a top wall; s a distance; x horizontal direction; y vertical direction.

## Claims

1. A cooling arrangement (1) of a subsea installation (2), wherein the subsea installation (2) comprises a tank (3) and a pressure compensator (4), the tank (3) comprising an insulation fluid (5) or other fluid, and the pressure compensator (1) is in fluid communication with the tank (3), the pressure compensator (4) is configured to compensate volume variations of the insulation fluid (5) or the other fluid by performing an expansive and a contracting movement, **characterized in that** the tank (3) and the pressure compensator (4) are connected with a first (6) fluid flow connection and a second (7) fluid flow connection, whereby the first fluid flow connection (6) provides a flow path from the tank (3) to the pressure compensator (4) and the second fluid flow connection (7) provides a flow path from the pressure compensator (4) to the tank (3), the first fluid flow connection (6) and the second fluid flow connection (7) providing a fluid circulation path between the tank (3) and the pressure compensator (4).

2. A cooling arrangement (1) according to claim 1, **characterized in that** the first fluid flow connection (6) is arranged between an upper part (12a) of the tank (3) and an upper part (13a) of the pressure compensator (4), and the second fluid flow connection (7) is arranged between a lower part (12b) of the tank (3) and a lower part (13b) of the pressure compensator (4).

3. A cooling arrangement (1) according to any of claims 1-2, **characterized in that** the first fluid flow connection (6) and/or the second fluid flow connection (7) comprises fluid flow deflectors (14) inside the tank (3) and/or inside the pressure compensator (4).

4. A cooling arrangement (1) according to claim 3, **characterized in that** the fluid flow deflectors (14) comprise pipes.

5. A cooling arrangement (1) according to any of claims 1-4, **characterized in that** the tank (3) and the pressure compensator (4) are arranged besides each other in a horizontal direction (x) at a distance (s) apart.

6. A cooling arrangement (1) according to any of claims 1-4, **characterized in that** the tank (3) and the pressure compensator (4) are arranged the tank (3) below the pressure compensator (4) in a vertical direction (y) at a distance (s) apart.

7. A cooling arrangement (1) according to any of claims 1-6, **characterized in that** the arrangement comprises two pressure compensators (4), one first fluid flow connection (6) between the tank (3) and one pressure compensator (4), another first fluid flow connection (6) between the tank (3) and another pressure compensator (4), one second fluid flow connection (7) between the tank (3) and one pressure compensator (4), and another second fluid flow connection (7) between the tank (3) and another pressure compensator (4).

8. A cooling arrangement (1) according to claim 7, **characterized in that** the second fluid flow connections (7) comprise fluid flow deflectors (14) inside the tank (3) which are joined to form a single inlet opening (15) inside the tank (3).

9. A cooling arrangement (1) according to any of claims 1-6, **characterized in that** the arrangement comprises two pressure compensators (4), the first fluid flow connection (6) comprises one outlet opening (16) in the tank (3) and one inlet opening (15) in each pressure compensator (4), and the second fluid flow connection (7) comprises one inlet opening (15) in the tank (3) and one outlet opening (16) in each pressure compensator (4).

10. A cooling arrangement (1) according to any of claims 1-6, **characterized in that** the arrangement comprises a plurality of pressure compensators (4).

11. A cooling arrangement (1) according to any of claims 1-10, **characterized in that** the pressure compensator comprises an end wall (17a) which is movable providing the expansive and the contracting movement of the pressure compensator (4).

12. A cooling arrangement (1) according to claim 11, **characterized in that** the end wall (17a) of the pressure compensator is movable in the vertical direction (y) or in the horizontal direction (x).

13. A cooling arrangement (1) according to any of claims 11-12, **characterized in that** the pressure compensator (4) comprises a first travel stop (18a) and a second travel stop (18b), and the first (18a) and the second travel stops (18b) are configured to block the movement of the movable end wall (17a-b) such that the first travel stop (18a) blocks the expansive movement and the second travel stop blocks (18b) the contracting movement.

14. A cooling arrangement (1) according to claim 13, **characterized in that** the first fluid flow connection (6) and the second fluid flow connection (7) in the pressure compensator (4) are arranged to the part (19) which is formed between a stationary end wall (17a-b) and the second travel stop blocks (18b).

15. A cooling arrangement (1) according to any of claims 1-14, **characterized in that** the pressure compensator (4) comprises a side wall (20) which is foldable and/or flexible providing the expansive and the contracting movement of the pressure compensator (4).

16. A cooling arrangement (1) according to any of claims 11 or 14, **characterized in that** the end wall (17a-b) comprises a recess (21).

17. A cooling arrangement (1) according to any of claims 1-16, **characterized in that** the pressure compensator (4) is a bellows pressure compensator.

18. A cooling arrangement (1) according to any of claims 1-14, **characterized in that** the pressure compensator (4) is a cylinder pressure compensator.

19. A cooling arrangement (1) according to any of claims 1-18, **characterized in that** the first fluid flow connection (6) and the second fluid flow connection (7) comprise pipes comprising a double barrier construction.

20. A cooling arrangement (1) according to any of claims 1-19, **characterized in that** a part of top wall (23) or a part of a side wall of the tank (3) forms a stationary end wall (17a-b) or a stationary side wall of the pressure compensator (4).

21. A cooling arrangement (1) according to any of claims 1-20, **characterized in that** the subsea installation (2) comprises a heat generating electric apparatus (8).

22. A cooling arrangement (1) according to any of claims 1-21, **characterized in that** that the subsea installation (2) comprises a subsea transformer or a subsea converter transformer.

23. A cooling arrangement (1) according to claim 22, **characterized in that** transformer windings and a transformer core are located within the tank (3).

24. A cooling arrangement (1) according to any of claims 1-23, **characterized in that** the insulation fluid (5) or other fluid comprises a liquid.

25. Use of a cooling arrangement (1) of a subsea installation according to any of claims 1-24 in a subsea environment.

## Patentansprüche

1. Kühlanordnung (1) einer Unterwasseranlage (2), wobei die Unterwasseranlage (2) einen Tank (3) und eine Druckausgleichsvorrichtung (4) umfasst, wobei der Tank (3) ein Isolierfluid (5) oder ein anderes Fluid enthält und die Druckausgleichsvorrichtung (1) in Fluidkommunikation mit dem Tank (3) ist, wobei die Druckausgleichsvorrichtung (4) konfiguriert ist, Volumenschwankungen des Isolierfluids (5) oder des anderen Fluids auszugleichen, indem eine Ausdehn- und eine Zusammenziehbewegung durchgeführt wird, **dadurch gekennzeichnet, dass** der Tank (3) und die Druckausgleichsvorrichtung (4) mit einer ersten (6) Fluiddurchflussverbindung und einer zweiten (7) Fluiddurchflussverbindung verbunden sind, wobei die erste Fluiddurchflussverbindung (6) einen Durchflussweg von dem Tank (3) zu der Druckausgleichsvorrichtung (4) bereitstellt und die zweite Fluiddurchflussverbindung (7) einen Durchflussweg von der Druckausgleichsvorrichtung (4) zu dem Tank (3) bereitstellt, wobei die erste Fluiddurchflussverbindung (6) und die zweite Fluiddurchflussverbindung (7) einen Fluidumlaufweg zwischen dem Tank (3) und der Druckausgleichsvorrichtung (4) bereitstellen.

2. Kühlanordnung (1) nach Anspruch 1, **dadurch gekennzeichnet, dass** die erste Fluiddurchflussverbindung (6) zwischen einem oberen Teil (12a) des Tanks (3) und einem oberen Teil (13a) der Druckausgleichsvorrichtung (4) angeordnet ist und die zweite Fluiddurchflussverbindung (7) zwischen einem unteren Teil (12b) des Tanks (3) und einem unteren Teil (13b) der Druckausgleichsvorrichtung (4) angeordnet ist.

3. Kühlanordnung (1) nach einem der Ansprüche 1-2, **dadurch gekennzeichnet, dass** die erste Fluiddurchflussverbindung (6) und/oder die zweite Fluiddurchflussverbindung (7) Fluidströmungsablenkvorrichtungen (14) in dem Tank (3) und/oder in der Druckausgleichsvorrichtung (4) umfassen.

4. Kühlanordnung (1) nach Anspruch 3, **dadurch gekennzeichnet, dass** die Fluidströmungsablenkvorrichtungen (14) Rohre umfassen.

5. Kühlanordnung (1) nach einem der Ansprüche 1-4, **dadurch gekennzeichnet, dass** der Tank (3) und die Druckausgleichsvorrichtung (4) in einer horizontalen Richtung (x) mit einem Abstand (s) getrennt nebeneinander angeordnet sind.

6. Kühlanordnung (1) nach einem der Ansprüche 1-4, **dadurch gekennzeichnet, dass** der Tank (3) und die Druckausgleichsvorrichtung (4) so angeordnet sind, dass sich der Tank (3) in einer vertikalen Richtung (y) getrennt um einem Abstand (s) unter der Druckausgleichsvorrichtung (4) befindet.

7. Kühlanordnung (1) nach einem der Ansprüche 1-6, **dadurch gekennzeichnet, dass** die Anordnung zwei Druckausgleichsvorrichtungen (4), eine erste Fluiddurchflussverbindung (6) zwischen dem Tank (3) und der einen Druckausgleichsvorrichtung (4), eine weitere erste Fluiddurchflussverbindung (6) zwischen dem Tank (3) und der weiteren Druckausgleichsvorrichtung (4), eine zweite Fluiddurchflussverbindung (7) zwischen dem Tank (3) und der einen Druckausgleichsvorrichtung (4) und eine weitere zweite Fluiddurchflussverbindung (7) zwischen dem Tank (3) und der weiteren Druckausgleichsvorrichtung (4) umfasst.

8. Kühlanordnung (1) nach Anspruch 7, **dadurch gekennzeichnet, dass** die zweiten Fluiddurchflussverbindungen (7) Fluidströmungsablenkvorrichtungen (14) in dem Tank (3) umfassen, die zusammengefügt sind, um eine einzelne Einlassöffnung (15) in dem Tank (3) zu bilden.

9. Kühlanordnung (1) nach einem der Ansprüche 1-6, **dadurch gekennzeichnet, dass** die Anordnung zwei Druckausgleichsvorrichtungen (4) umfasst, die erste Fluiddurchflussverbindung (6) eine Auslassöffnung (16) in den Tank (3) und eine Einlassöffnung (15) in jede Druckausgleichsvorrichtung (4) umfasst und die zweite Fluiddurchflussverbindung (7) eine Einlassöffnung (15) in den Tank (3) und eine Auslassöffnung (16) in jede Druckausgleichsvorrichtung (4) umfasst.

10. Kühlanordnung (1) nach einem der Ansprüche 1-6, **dadurch gekennzeichnet, dass** die Anordnung mehrere Druckausgleichsvorrichtungen (4) umfasst.

11. Kühlanordnung (1) nach einem der Ansprüche 1-10, **dadurch gekennzeichnet, dass** die Druckausgleichsvorrichtung eine Stirnwand (17a) umfasst, die beweglich ist und die Ausdehn- und die Zusammenziehbewegung der Druckausgleichsvorrichtung (4) bereitstellt.

12. Kühlanordnung (1) nach Anspruch 11, **dadurch gekennzeichnet, dass** die Stirnwand (17a) der Druckausgleichsvorrichtung in der vertikalen Richtung (y) oder in der horizontalen Richtung (x) beweglich ist.

13. Kühlanordnung (1) nach einem der Ansprüche 11-12, **dadurch gekennzeichnet, dass** die Druckausgleichsvorrichtung (4) einen ersten Bewegungsanschlag (18a) und einen zweiten Bewegungsanschlag (18b) umfasst und der erste (18a) und der zweite Bewegungsanschlag (18b) konfiguriert sind, die Bewegung der beweglichen Stirnwand (17a-b) so zu blockieren, dass der erste Bewegungsanschlag (18a) die Ausdehnbewegung blockiert und der zweite Bewegungsanschlag (18b) die Zusammenziehbewegung blockiert.

14. Kühlanordnung (1) nach Anspruch 13, **dadurch gekennzeichnet, dass** die erste Fluiddurchflussverbindung (6) und die zweite Fluiddurchflussverbindung (7) in der Druckausgleichsvorrichtung (4) zu dem Teil (19) angeordnet sind, der zwischen einer feststehenden Stirnwand (17a-b) und den zweiten Bewegungsanschlägen (18b) gebildet ist.

15. Kühlanordnung (1) nach einem der Ansprüche 1-14, **dadurch gekennzeichnet, dass** die Druckausgleichsvorrichtung (4) eine Seitenwand (20) umfasst, die faltbar und/oder biegsam ist und die Ausdehn- und die Zusammenziehbewegung der Druckausgleichsvorrichtung (4) bereitstellt.

16. Kühlanordnung (1) nach einem der Ansprüche 11 oder 14, **dadurch gekennzeichnet, dass** die Stirnwand (17a-b) eine Vertiefung (21) umfasst.

17. Kühlanordnung (1) nach einem der Ansprüche 1-16, **dadurch gekennzeichnet, dass** die Druckausgleichsvorrichtung (4) eine Faltenbalgdruckausgleichsvorrichtung ist.

18. Kühlanordnung (1) nach einem der Ansprüche 1-14, **dadurch gekennzeichnet, dass** die Druckausgleichsvorrichtung (4) eine Zylinderdruckausgleichsvorrichtung ist.

19. Kühlanordnung (1) nach einem der Ansprüche 1-18, **dadurch gekennzeichnet, dass** die erste Fluiddurchflussverbindung (6) und die zweite Fluiddurchflussverbindung (7) Rohre umfassen, die einen Doppelsperrenaufbau aufweisen.

20. Kühlanordnung (1) nach einem der Ansprüche 1-19, **dadurch gekennzeichnet, dass** ein Teil der oberen Wand (23) oder ein Teil einer Seitenwand des Tanks (3) eine feststehende Stirnwand (17a-b) oder eine feststehende Seitenwand der Druckausgleichsvorrichtung (4) bildet.

21. Kühlanordnung (1) nach einem der Ansprüche 1-20, **dadurch gekennzeichnet, dass** die Unterwasseranlage (2) eine wärmeerzeugende elektrische Einrichtung (8) umfasst.

22. Kühlanordnung (1) nach einem der Ansprüche 1-21, **dadurch gekennzeichnet, dass** die Unterwasseranlage (2) einen Unterwassertransformator oder einen Unterwasserumsetzertransformator umfasst.

23. Kühlanordnung (1) nach Anspruch 22, **dadurch gekennzeichnet, dass** sich die Transformatorwicklungen und ein Transformatorkern innerhalb des Tanks (3) befinden.

24. Kühlanordnung (1) nach einem der Ansprüche 1-23, **dadurch gekennzeichnet, dass** das Isolierfluid (5) oder ein anderes Fluid eine Flüssigkeit umfasst.

25. Verwendung einer Kühlanordnung (1) einer Unterwasseranlage nach einem der Ansprüche 1-24 in einer Unterwasserumgebung.

## Revendications

1. Agencement de refroidissement (1) d'une installation sous-marine (2), dans lequel l'installation sous-marine (2) comprend un réservoir (3) et un compensateur de pression (4), le réservoir (3) comprenant un fluide d'isolation (5) ou un autre fluide, et le compensateur de pression (1) est en communication fluidique avec le réservoir (3), le compensateur de pression (4) est configuré pour compenser des variations de volume du fluide d'isolation (5) ou de l'autre fluide en effectuant un mouvement d'expansion et de contraction, **caractérisé en ce que** le réservoir (3) et le compensateur de pression (4) sont raccordés à un premier (6) raccord d'écoulement de fluide et un deuxième (7) raccord d'écoulement de fluide, de sorte que le premier raccord d'écoulement de fluide (6) fournit un chemin d'écoulement du réservoir (3) au compensateur de pression (4) et le deuxième raccord d'écoulement de fluide (7) fournit un chemin d'écoulement du compensateur de pression (4) au réservoir (3), le premier raccord d'écoulement de fluide (6) et le deuxième raccord d'écoulement de fluide (7) fournissant un chemin de circulation de fluide entre le réservoir (3) et le compensateur de pression (4).

2. Agencement de refroidissement (1) selon la revendication 1, **caractérisé en ce que** le premier raccord d'écoulement de fluide (6) est agencé entre une partie supérieure (12a) du réservoir (3) et une partie supérieure (13a) du compensateur de pression (4), et le deuxième raccord d'écoulement de fluide (7) est agencé entre une partie inférieure (12b) du réservoir (3) et une partie inférieure (13b) du compensateur de pression (4) .

3. Agencement de refroidissement (1) selon l'une quelconque des revendications 1 et 2, **caractérisé en ce que** le premier raccord d'écoulement de fluide (6) et/ou le deuxième raccord d'écoulement de fluide (7) comprennent des déflecteurs d'écoulement de fluide (14) à l'intérieur du réservoir (3) et/ou à l'intérieur du compensateur de pression (4).

4. Agencement de refroidissement (1) selon la revendication 3, **caractérisé en ce que** les déflecteurs d'écoulement de fluide (14) comprennent des tuyaux.

5. Agencement de refroidissement (1) selon l'une quelconque des revendications 1 à 4, **caractérisé en ce que** le réservoir (3) et le compensateur de pression (4) sont agencés côte à côte dans une direction horizontale (x), espacés d'une distance (s).

6. Agencement de refroidissement (1) selon l'une quelconque des revendications 1 à 4, **caractérisé en ce que** le réservoir (3) et le compensateur de pression (4) sont agencés avec le réservoir (3) au-dessous du compensateur de pression (4) dans une direction verticale (y), espacés d'une distance (s).

7. Agencement de refroidissement (1) selon l'une quelconque des revendications 1 à 6, **caractérisé en ce que** l'agencement comprend deux compensateurs de pression (4), un premier raccord d'écoulement de fluide (6) entre le réservoir (3) et un compensateur de pression (4), un autre premier raccord d'écoulement de fluide (6) entre le réservoir (3) et un autre compensateur de pression (4), un deuxième raccord d'écoulement de fluide (7) entre le réservoir (3) et un compensateur de pression (4), et un deuxième raccord d'écoulement de fluide (7) entre le réservoir (3) et un autre compensateur de pression (4).

8. Agencement de refroidissement (1) selon la revendication 7, **caractérisé en ce que** les deuxièmes raccords d'écoulement de fluide (7) comprennent des déflecteurs d'écoulement de fluide (14) à l'intérieur du réservoir (3) qui sont reliés pour former une seule ouverture d'entrée (15) à l'intérieur du réservoir (3).

9. Agencement de refroidissement (1) selon l'une quelconque des revendications 1 à 6, **caractérisé en ce que** l'agencement comprend deux compensateurs de pression (4), le premier raccord d'écoulement de fluide (6) comprend une ouverture de sortie (16) dans le réservoir (3) et une ouverture d'entrée (15) dans chaque compensateur de pression (4), et le deuxième raccord d'écoulement de fluide (7) comprend une ouverture d'entrée (15) dans le réservoir (3) et une ouverture de sortie (16) dans chaque compensateur de pression (4).

10. Agencement de refroidissement (1) selon l'une quelconque des revendications 1 à 6, **caractérisé en ce que** l'agencement comprend une pluralité de compensateurs de pression (4).

11. Agencement de refroidissement (1) selon l'une quelconque des revendications 1 à 10, **caractérisé en ce que** le compensateur de pression comprend une paroi d'extrémité (17a) qui est mobile et fournit le mouvement d'expansion et de contraction du compensateur de pression (4).

12. Agencement de refroidissement (1) selon la revendication 11, **caractérisé en ce que** la paroi d'extrémité (17a) du compensateur de pression est mobile dans la direction verticale (y) ou dans la direction horizontale (x).

13. Agencement de refroidissement (1) selon l'une quelconque des revendications 11 et 12, **caractérisé en ce que** le compensateur de pression (4) comprend un premier limiteur de course (18a) et un deuxième limiteur de course (18b), et les premier (18a) et deuxième limiteurs de course (18b) sont configurés pour bloquer le mouvement de la paroi d'extrémité mobile (17a-b) de telle sorte que le premier limiteur de course (18a) bloque le mouvement d'expansion et le deuxième limiteur de course bloque (18b) le mouvement de contraction.

14. Agencement de refroidissement (1) selon la revendication 13, **caractérisé en ce que** le premier raccord d'écoulement de fluide (6) et le deuxième raccord d'écoulement de fluide (7) dans le compensateur de pression (4) sont agencés sur la partie (19) qui est formée entre une paroi d'extrémité stationnaire (17a-b) et les blocages du deuxième limiteur de course (18b).

15. Agencement de refroidissement (1) selon l'une quelconque des revendications 1 à 14, **caractérisé en ce que** le compensateur de pression (4) comprend une paroi latérale (20) qui est pliable et/ou souple et fournit le mouvement d'expansion et de contraction du compensateur de pression (4).

16. Agencement de refroidissement (1) selon l'une quelconque des revendications 11 ou 14, **caractérisé en ce que** la paroi d'extrémité (17a-b) comprend un retrait (21) .

17. Agencement de refroidissement (1) selon l'une quelconque des revendications 1 à 16, **caractérisé en ce que** le compensateur de pression (4) est un compensateur de pression à soufflet.

18. Agencement de refroidissement (1) selon l'une quelconque des revendications 1 à 14, **caractérisé en ce que** le compensateur de pression (4) est un compensateur de pression à vérin.

19. Agencement de refroidissement (1) selon l'une quelconque des revendications 1 à 18, **caractérisé en ce que** le premier raccord d'écoulement de fluide (6) et le deuxième raccord d'écoulement de fluide (7) comprennent des tuyaux comprenant une construction à double barrière.

20. Agencement de refroidissement (1) selon l'une quelconque des revendications 1 à 19, **caractérisé en ce qu'**une partie de la paroi supérieure (23) ou une partie d'une paroi latérale du réservoir (3) forme une paroi d'extrémité stationnaire (17a-b) ou une paroi latérale stationnaire du compensateur de pression (4).

21. Agencement de refroidissement (1) selon l'une quelconque des revendications 1 à 20, **caractérisé en ce que** l'installation sous-marine (2) comprend un appareil électrique générateur de chaleur (8).

22. Agencement de refroidissement (1) selon l'une quelconque des revendications 1 à 21, **caractérisé en ce que** l'installation sous-marine (2) comprend un transformateur sous-marin ou un transformateur convertisseur sous-marin.

23. Agencement de refroidissement (1) selon la revendication 22, **caractérisé en ce que** des enroulements de transformateur et un noyau de transformateur sont situés à l'intérieur du réservoir (3) .

24. Agencement de refroidissement (1) selon l'une quelconque des revendications 1 à 23, **caractérisé en ce que** le fluide d'isolation (5) ou l'autre fluide comprend un liquide.

25. Utilisation d'un agencement de refroidissement (1) d'une installation sous-marine selon l'une quelconque des revendications 1 à 24 dans un environnement sous-marin.
